# EUROPÄISCHE PATENTANMELDUNG

(11) **EP 3 795 605 A1**
(43) Veröffentlichungstag der Anmeldung: **24.03.2021**
(21) Anmeldenummer: 20200732.4
(22) Anmeldetag: 12.05.2016
(51) Int. Cl.: C08G 59/68, C09J 163/00

(54) **VERFAHREN ZUR HERSTELLUNG VISKOSER EPOXIDSIRUPE UND DANACH ERHÄLTLICHE EPOXIDSIRUPE**

(30) Priorität: 04.06.2015 DE 102015210346
(62) Teilanmeldung aus: 16169349.4
(71) Anmelder: tesa SE, 22848 Norderstedt (DE)
(72) Erfinder: KEITE-TELGENBÜSCHER, Klaus, 22529 Hamburg (DE); SCHUH, Christian, 22767 Hamburg (DE); SHU, Yao, 72160 Horb am Neckar (DE)
(74) Vertreter: tesa SE

(57) **Zusammenfassung**

Ein Verfahren zur Herstellung eines viskosen Epoxidsirups aus mindestens einem flüssigen multifunktionellen Epoxid, umfassend die Schritte:
- Zugeben eines Initiators, ausgewählt aus der Gruppe bestehend aus elektronenarmem Monoisocyanat, Photoinitiator und thermischem Initiator, zu mindestens einem flüssigen multifunktionellen Epoxid;
- Vermischen der Komponenten;
- Polymerisieren des multifunktionellen Epoxids derart, dass die Viskosität des resultierenden Epoxidsirups mindestens doppelt so hoch, vorzugsweise mindestens viermal so hoch und insbesondere mindestens zehnmal so hoch ist wie die des eingesetzten Epoxides im nicht-umgesetzten Zustand ermöglicht es Epoxidklebmassen mit haftklebrigen Eigenschaften herzustellen.

## Beschreibung

Die vorliegende Erfindung betrifft Verfahren zur Herstellung eines viskosen Epoxidsirups aus mindestens einem flüssigen multifunktionellen Epoxid, umfassend die Schritte Zugeben eines Initiators, ausgewählt aus der Gruppe bestehend aus elektronenarmem Monoisocyanat, Photoinitiator und thermischem Initiator, zu mindestens einem flüssigen multifunktionellen Epoxid und Polymerisieren des multifunktionellen Epoxids, einen nach dem Verfahren erhältlichen viskosen Epoxidsirup, eine Klebemasse sowie ein Klebeband mit diesem Epoxidsirup sowie die Verwendung einer solchen Epoxidsirups, einer solchen Klebemasse oder eines solchen Klebebandes.

Epoxidklebemassen mit haftklebrigen Eigenschaften lassen sich über die Zugabe von Matrixpolymeren erzeugen. Häufig steigt die Verklebungsfestigkeit mit zunehmender Menge Epoxid. Da die meisten Epoxide in Flüssigklebern zum Einsatz kommen, sind sie relativ niedrigviskos, sodass hohe Epoxidgehalte keine haftklebrigen Tapes ergeben. Dazu werden hochviskose bzw. feste Epoxide benötigt.

Typischerweise wird die Viskosität von Epoxidharzen auf Epichlorhydrinbasis über das Verhältnis von Epichlorhydrin und einer daraus resultierenden Molekulargewichtserhöhung auf Kosten der Epoxidkonzentration eingestellt ["Epoxy Adhesive Formulations" 2006, E. M. Petrie, S.30ff]. Einige Beispiele wie Epoxy-(Cresol)-Novolake werden über eine andere Syntheseroute hergestellt und tragen die Epoxidgruppen als Seitengruppe, sodass eine Erhöhung des Molekulargewichtes nicht zu einer Reduktion der Epoxidkonzentration führt.

Außer den vorstehend genannten Epoxy-Novolaken und den mit Epichlorhydrin hergestellten Oligomeren gibt es jedoch keine Verfahren, Epoxide, insbesondere auch andere als die genannten, hochviskos zu erhalten.

Speziellere Epoxidmonomere wie beispielsweise Epoxycyclohexyl-Derivate, die nicht über die Epichlorhydrinroute hergestellt werden, sind dementsprechend häufig sehr flüssig (z.B. Uvacure 1500). Da viele Epoxide für vernetzende Reaktion eingesetzt werden (sie enthalten mehr als eine Epoxidgruppe pro Molekül), lassen diese sich auch nicht einfach polymerisieren, um die Viskosität zu erhöhen, da sich sofort vernetzte und unlösliche Niederschläge bilden. Diese Epoxycyclohexylmonomere werden bevorzugt in kationisch härtenden Klebmassen verwendet, insbesondere zur UV-induzierten Härtung über photolabile Säurenbildner.

Es besteht demnach der Bedarf einer Methode zur Erhöhung der Viskosität von Epoxiden, die nicht über den Epichlorhydrin-Weg erhalten werden.

Die AU 758128 B2 beschreibt solche lagerstabilen kationisch härtenden multifunktionelle Epoxidabmischungen. Um zu erreichen, dass die multifunktionellen Epoxidharze lagerstabil sind, ist es nach dieser Schrift erforderlich, eine ungewollte vorzeitige Polymerisation zu vermeiden. Dies wird erreicht, indem bei der Polymerisation von multifunktionellen Epoxidmonomeren 0,0005 bis 10 Gew.-% eines organischen und/oder anorganischen Erdalkali- oder Alkalimetallverbindung zugegeben werden. Eine Polymerisation vor gewünschter Vernetzung soll also in jedem Fall vermieden werden. Neben der erfindungsgemäßen Stabilisierung dieser Klebmassen geht aus dieser Schrift hervor, dass für kationisch härtbare Flüssigkleber Epoxycyclohexylderivate besonders bevorzugt sind, so dass es wünschenswert wäre, auch aus diesem Monomer hochviskose Epoxide herstellen zu können.

Die SG 160949 B schlägt vor, Di-Epoxide mit Di-Isocyanaten zu reagieren. Aus dieser Mischung bilden sich cyclische Trimere (Isocyanurate) und Oxazolidinone mit einem M_{w}< 3.000g/mol und einer niedrigen Polydispersität, die man dann wie Epoxide aushärten kann. Dabei ist erforderlich, dass mindestens difunktionelle Substanzen zum Einsatz kommen, da andernfalls keine reaktiven Gruppen für die nachfolgende Aushärtung zur Verfügung stünden. Die entstehenden Verbindungen weisen jedoch niedrige Viskositäten auf.

Aufgabe der vorliegenden Erfindung war es daher, ein Verfahren bereitzustellen, das es ermöglicht, gezielt viskose Klebharze aus ursprünglich flüssigen Epoxiden herzustellen. Das Produkt soll in Lösungsmitteln löslich und durch Temperaturerhöhung schmelzbar sein.

Gelöst wird die Aufgabe durch ein Verfahren der eingangs genannten Art, bei dem die Komponenten zunächst vermischt werden und das Polymerisieren des multifunktionellen Epoxids im Anschluss derart erfolgt, dass die Viskosität des resultierenden Epoxidsirups mindestens doppelt so hoch, vorzugsweise mindestens viermal so hoch und insbesondere mindestens zehnmal so hoch ist wie die des eingesetzten Epoxides im nicht-umgesetzten Zustand. Dabei werden die Epoxide derart anpolymerisiert, dass hochmolekulare Polyepoxide aus z.B. Bis-Epoxymonomeren erzeugt werden, ohne dass diese vernetzen. Die so erhaltenen Epoxidsirupe sind bestens geeignet, um Epoxidklebmassen mit haftklebrigen Eigenschaften herzustellen. Wichtig ist dabei, dass die Initiation erst erfolgt, nachdem der Initiator gut verteilt im Epoxid vorliegt. Sonst liegen die reaktiven Zentren zu nah beieinander und es kommt zur Vernetzung, die in diesem Stadium noch nicht gewünscht ist. Um ein Vermischen zu erreichen, kann beispielsweise gerührt werden, aber auch andere Formen des Vermischens sind denkbar und möglich.

Alle in dieser Anmeldung gemachten Viskositätsangaben beziehen sich, sofern nichts anderes angegeben ist, auf eine Messung bei 23°C nach DIN 53019-1.

"Epoxidsirup" bezeichnet dabei solche Epoxide, deren Viskosität mindestens 1 Pa·s (entsprechend 1.000 mPs) beträgt.

Besonders vorteilhaft wird das erfindungsgemäße Verfahren derart durchgeführt, dass in dem resultierenden Epoxidsirup mindestens 65%, bevorzugt mindestens 75%, insbesondere mindestens 80% der ursprünglichen Epoxidgruppen noch vorhanden sind. Im Sirup liegt somit ein großer Teil der Epoxideinheiten noch in der Monomerenform vor. Entsprechend ist es weiterhin vorteilhaft, wenn der resultierende Epoxidsirup hochmolekulare unvernetzte Polyepoxide enthält. Besonders günstig ist es also, wenn im Epoxid-sirup nach wie vor eine große Menge der eingesetzten multifunktionellen Epoxidmonomeren unreagiert als Monomer vorliegt und sich nur vereinzelt hochmolekulare Polyepoxide gebildet haben, die allerdings noch unvernetzt sind.

Als multifunktionelle Epoxide sind Bis-Epoxide besonders geeignet. Nach erfolgter Polymerisation steht eine weitere Epoxidgruppe zur Verfügung, die später im Epoxidklebharz die Vernetzung bewirken kann.

Als multifunktionelle Epoxide haben sich Bis-Epoxycyclohexyl-Derivate, insbesondere 3,4-Epoxycyclohexylmethyl-3,4-Epoxycyclohexan Carboxylat, und Bis-Epoxide auf Basis von Bisphenol-A, Bisphenol-S oder Bisphenol-F als besonders vorteilhaft herausgestellt. Mit ihnen lassen sich Sirupe herstellen, deren Viskosität gut geeignet ist, um die Epoxide zu haftklebrigen Epoxidharzen weiter zu verarbeiten.

Besonders gut lässt sich das erfindungsgemäße Verfahren durchführen, wenn der Initiator ausgewählt ist aus der Gruppe bestehend aus Photoinitiator und thermischem Initiator und in einer Menge von höchstens 0,1 Gew.-%, vorzugsweise höchstens 0,08 Gew.-%, besonders bevorzugt höchstens 0,05 Gew.-% eingesetzt wird. Damit können die angestrebten Viskositäten auf besonders einfache und gut handhabbare Weise erreicht werden.

Neben diesen klassischen Initiatoren zur kationischen Epoxidhärtung sind überraschenderweise auch spezielle Isocyanate als Initiatoren für die vorliegende Erfindung besonders geeignet.

Besonders geeignet als Initiator ist dabei ein elektronenarmes Monoisocyanat, das in einer Menge von höchstens 10 Gew.-%, vorzugsweise höchstens 8 Gew.-% und insbesondere höchstens 7 Gew.-% eingesetzt wird. Die Reaktion lässt sich besonders gut kontrollieren, wenn das Monoisocyanat in einer Menge von 7 ± 0,5 Gew.-% eingesetzt wird. Geeignete Monoisocyanate sind insbesondere ausgewählt aus der Gruppe bestehend aus p-Tolylisocyanat, o-Tolylisocyanat und Sulfonylisocyanaten, dabei insbesondere p-Toluolsulfonylmethylisocyanat, o-Toluolsulfonylmethylisocyanat, 4-Chlorbenzylsulfonylisocyanat, o-Toluolsulfonylisocyanat, p-Toluolsulfonylisocyanat und Benzylsulfonylisocyanat, wobei p-Toluolsulfonylisocyanat besonders bevorzugt ist.

Als Temperaturbereich zur Durchführung des Verfahrens hat sich der Bereich zwischen 20 und 120°C, vorzugsweise zwischen 40 und 100°C, insbesondere zwischen 80 und 90°C, als besonders vorteilhaft herausgestellt.

Temperatur und Initiatormenge stehen dabei in einer Wechselwirkung. Je mehr Initiator zugesetzt wird, desto niedriger kann die Temperatur sein, um die gleiche Reaktionsgeschwindigkeit zu erreichen. Während z.B. im Falle der elektronenarmen Isocyanate 10 Gew.-% Initiator bei Raumtemperatur nur eine sehr langsame Geschwindigkeit bewirken, reicht bei 85°C eine Menge von 7 Gew.-% Initiator aus, um die Reaktion innerhalb weniger Stunden durchzuführen.

Weiterhin ist es vorteilhaft, wenn die Polymerisation bei Erreichen einer gewünschten Viskosität durch Zugabe eines Initiatorfängers gestoppt wird. Dadurch ist es möglich, die erhaltenen Epoxidsirupe lagerstabil zu machen. Selbst bei höheren Temperaturen von z.B. 80°C sind die erhaltenen Epoxidsirupe über mehrere Monate lagerstabil. Als Initiatorfänger sind ein Gemisch aus Wasser und Aceton, Lösungen von (Erd-)Alkalihydroxiden oder Lösungen von (Erd-)Alkalialkoxiden besonders geeignet. Im Falle der Verwendung eines Gemisches aus Wasser und Aceton ist ein Verhältnis der beiden Komponenten von 1:1 besonders bevorzugt.

Die Menge an Initiatorfänger sollte dabei vorzugsweise der Menge an Initiator entsprechen bzw. im Wesentlichen entsprechen. Bei der Verwendung von 7 g Initiator werden also vorteilhafter Weise auch 7 g Initiatorfänger einesetzt.

Besonders vorteilhaft ist das erfindungsgemäße Verfahren darüber hinaus, wenn das Polymerisieren des multifunktionellen Epoxids derart erfolgt, dass der resultierende Epoxidsirup eine Polydispersität D von mindestens 3, vorzugsweise mindestens 5, insbesondere von mindestens 8 aufweist. Dabei wird die Polydispersität nicht etwa dadurch erhalten, dass verschiedene Polymere gemischt werden, sondern dass sich aufgrund der Reaktionsbedingungen ganz unterschiedlich große Polymermoleküle bilden. Die Polydispersität D ist ein Maß für die Verteilung der Molmassen. Die Polydispersität D ist definiert als gewichtsmittleres Molekulargewicht M_{w} / zahlenmittleres Molekulargewicht Mₙ der vorhandenen Polymere. Eine großer Wert für die Polydispersität bedeutet somit eine breite Molmassenverteilung von sehr kurzkettigen bis zu langkettigen Makromolekülen, d.h. es liegen Moleküle vieler verschiedener Kettenlängen im Polymer vor.

Für die vorliegende Erfindung bedeutet dies, dass die mono-, bi- bzw. multimodale Molekulargewichtsverteilung derart ausgebildet ist, dass von niedermolekularen Bestandteilen (< 2.000 g/mol) durchgängig bis hin zu sehr hochmolekularen Bestandteilen (> 300.000 g/mol) Moleküle zu finden sind.

Diese Besonderheit der Molekulargewichtsverteilung trägt insbesondere zu den erfindungsgemäß vorteilhaften Eigenschaften eines hohen Epoxidgehaltes (viele niedermolekulare Bis-Epoxide) und gleichzeitig hochviskosem Verhalten (sehr hochmolekulare Epoxide) des Produktes bei.

Überraschend konnte festgestellt werden, dass das erfindungsgemäße Verfahren zu einer langsamen Erhöhung der Viskosität während der Polymerisation führt. Die Viskositätserhöhung ist auf die Bildung von sehr hochmolekularen Polyepoxiden zurückzuführen. Obwohl es sich um multifunktionelle, insbesondere zweifach funktionelle, Epoxide handelt, die sehr schnell unlösliche hochvernetzte Netzwerke ausbilden, bleiben die mit diesem Verfahren hergestellten Epoxidklebharze löslich. Dieses Verhalten wird damit erklärt, dass relativ wenige initiierende Spezies durch den Initiator wie z.B. das p-Toluolsulfonylmethylisocyanat gebildet werden, sich die wachsenden Ketten somit nicht treffen können, deswegen bei sehr niedrigen Epoxidumsätzen wenige sehr hochmolekulare Polymere gebildet werden. GPC-Messungen und FT-IR Spektren unterstützen diese Theorie. Wichtig ist dabei, dass die Initiation erst erfolgt, nachdem der Initiator gut verteilt im Epoxid vorliegt, damit in diesem Stadium keine Vernetzung erfolgt.

Die Erfindung betrifft des Weiteren viskose Epoxidsirupe, die nach dem erfindungsgemäßen Verfahren erhältlich sind. Ferner betrifft die vorliegende Erfindung viskose Epoxidsirupe, enthaltend multifunktionelle Epoxidmonomere und aus diesen erzeugte hochmolekulare unvernetzte multifunktionelle Polyepoxide, wobei die Viskosität des Epoxidsirups mindestens doppelt so hoch, vorzugsweise mindestens viermal so hoch und insbesondere mindestens zehnmal so hoch ist wie die des eingesetzten Epoxides im nicht-umgesetzten Zustand.

Vorzugsweise umfasst dabei die Molgewichtsverteilung der im Epoxidsirup enthaltenen Polyepoxide mindestens den Bereich von 2.000 g/mol bis 300.000 g/mol. Das bedeutet, es liegen im Epoxidsirup Epoxidmoleküle mit sehr unterschiedlichem Molgewicht vor, von ganz gering bis sehr hoch, wobei von den niedermolekularen (< 2.000 g/mol) bis hin zu den hochmolekularen (> 300.000 g/mol) Verbindungen durchgängig alle enthalten sind. Es können auch Verbindungen mit geringerem oder noch höherem Molgewicht enthalten sein.

Vorzugsweise beträgt bei den erfindungsgemäßen Epoxidsirupen der Viskositätsanstieg bei Lagerung bei 25°C pro Tag weniger als 5 Pa s. Damit ist eine ausreichende Lagerstabilität gegeben, die es ermöglicht, die Epoxidsirupe über einen längeren Zeitraum zu lagern, bevor sie zum Einsatz kommen.

Besonders bevorzugt sind viskose Epoxidsirupe, bei denen das Epoxidmonomer 3,4-Epoxycyclohexylmethyl-3,4-Epoxycyclohexancarboxylat ist und die Viskosität mindestens 1 Pa s (1.000 mPs) bevorzugt 10 Pa s (10.000 mPs), insbesondere 25 Pa s (25.000 mPs) beträgt.

Die vorliegende Erfindung betrifft auch eine wasserdampfsperrende Klebemasse, enthaltend eine Klebstoffbasis aus mindestens einem erfindungsgemäßen Epoxidsirup, mindestens einem Elastomer, optional ein Lösungsmittel, wobei die Klebstoffbasis eine Wasserdampfpermeationsrate nach der Aktivierung der Reaktivharzkomponente von weniger als 100 g/m²d, bevorzugt von weniger als 60 g/m²d, insbesondere weniger als 30 g/m²d aufweist. Für solche wasserdampfsperrenden Klebemassen sind die erfindungsgemäßen Epoxidsirupe sehr gut geeignet, da sie sich aufgrund ihrer Viskosität gut verarbeiten lassen und vor allem ermöglichen, Klebemassen mit einer hinreichenden Viskosität herzustellen, so dass die so erhaltenen Klebemassen gut handhabbar und einfach applizierbar sind.

Des Weiteren betrifft die vorliegende Erfindung ein Klebeband enthaltend einen erfindungsgemäßen viskosen Epoxidsirup oder eine erfindungsgemäße wasserdampfsperrende Klebemasse. Solche Klebebänder ermöglichen eine besonders einfache Applikation.

Ein Anwendungsgebiet, für das sich die vorliegenden Epoxidsirupe bzw. die daraus hergestellte Klebemasse oder das daraus hergestellte Klebeband hervorragend eignen, ist die Verkapselung von Aufbauten in der organischen Elektronik. Aber auch unzählige weitere Anwendungen, für die eine haftklebrige Epoxidharzklebemasse benötigt wird, sind denkbar.

Besonders bevorzugte Initiatioren für die Polymerisationsreaktion sind, wie bereits ausgeführt, elektronenarme Mono-Isocyanate wie beispielsweise p-Tolyl isocyanat, p-Toluolsulfonylmethylisocyanat, o-Tolylisocyanat oder o-Toluolsulfonylmethylisocyanat. Insbesondere bevorzugt sind Derivate von Sulfonylisocyanaten (R-SO₂-NCO, R-SO₂-CH₂-NCO) wie beispielsweise 4-Chlorbenzylsulfonylisocyanat, o-Toluolsulfonylisocyanat, p-Toluolsulfonylisocyanat, Benzylsulfonylisocyanat.

Photoinitiatoren, mit denen die erfindungsgemäßen Molekulargewichtsverteilungen erzielt werden können, sind beispielsweise, jedoch nicht ausschließlich

Sulfonium-Salze (siehe zum Beispiel US 4,231,951 A, US 4,256,828 A, US 4,058,401 A, US 4,138,255 A und US 2010/063221 A1) wie Triphenylsulfoniumhexafluoroarsenat, Triphenylsulfoniumhexafluoroborat, Triphenylsulfoniumtetrafluoroborat, Triphenylsulfoni-umtetrakis-(pentafluorobenzyl)-borat, Methyldiphenylsulfoniumtetrafluoroborat, Methyl-diphenylsulfoniumtetrakis-(pentafluorobenzyl)-borat, Dimethylphenylsulfoniumhexafluorophosphat, Triphenylsulfoniumhexafluorophosphat, Triphenylsulfoniumhexafluoroantimonat, Diphenylnaphthylsulfoniumhexafluoroarsenat, Tritolylsulfoniumhexafluorophosphat, Anisyldiphenylsulfoniumhexafluoroantimonat, 4-Butoxyphenyldiphenylsulfoniumtetrafluoroborat, 4-Butoxyphenyldiphenylsulfoniumtetrakis-(pentafluorobenzyl)-borat, 4-Chlorophenyldiphenylsulfoniumhexafluoroantimonat, Tris-(4-phenoxyphenyl)-sulfoniumhexafluorophosphat, Di-(4-ethoxyphenyl)-methylsulfoniumhexafluoroarsenat, 4-Acetylphenyldiphenylsulfoniumtetrafluoroborat, 4-Acetylphenyldiphenylsulfoniumtetrakis-(pentafluorobenzyl)-borat, Tris-(4-thiomethoxyphenyl)-sulfoniumhexafluorophosphat, Di-(methoxysulfonylphenyl)-methylsulfoniumhexafluoroantimonat, Di-(methoxynaphthyl)-methylsulfoniumtetrafluoroborat, Di-(methoxynaphthyl)-methylsulfoniumtetrakis-(pentafluorobenzyl)-borat, Di-(carbomethoxyphenyl)-methylsulfoniumhexafluorophosphat, (4-Octyloxyphenyl)-diphenylsulfoniumtetrakis-(3,5-bis-trifluoromethylphenyl)-borat, Tris-[4-(4-acetylphenyl)-thiophenyl]-sulfoniumtetrakis-(pentafluorophenyl)-borat, Tris-(dodecylphenyl)-sulfoniumtetrakis-(3,5-bis-trifluoromethylphenyl)-borat, 4-Acetamidphenyldiphenylsulfoniumtetrafluoroborat, 4-Acetamidphenyldiphenylsulfoniumtetrakis-(pentafluorobenzyl)-borat, Dimethylnaphthylsulfoniumhexafluorophosphat, Trifluoromethyldiphenylsulfoniumtetrafluoroborat, Trifluoromethyldiphenylsulfoniumtetrakis-(pentafluorobenzyl)-borat, Phenylmethylbenzylsulfoniumhexafluorophosphat, 5-Methylthianthreniumhexafluorophosphat, 10-Phenyl-9,9-dimethylthioxantheniumhexafluorophosphat, 10-Phenyl-9-oxothioxantheniumtetrafluoroborat, 10-Phenyl-9-oxothioxantheniumtetrakis-(pentafluorobenzyl)-borat, 5-Methyl-10-oxothianthreniumtetrafluoroborat, 5-Methyl-10-oxothianthreniumtetrakis-(pentafluorobenzyl)-borat und 5-Methyl-10,10-dioxothianthreniumhexafluorophosphat oder p-Toluolsulfonylisocyanat oder lodonium-Salze (siehe zum Beispiel US 3,729,313 A, US 3,741,769 A, US 4,250,053 A, US 4,394,403 A und US 2010/063221 A1) wie Diphenyliodoniumtetrafluoroborat, Di-(4-methylphenyl)-iodoniumtetrafluoroborat, Phenyl-4-methylphenyliodoniumtetrafluoroborat, Di-(4-chlorphenyl)-iodoniumhexafluorophosphat, Dinaphthyliodoniumtetrafluoroborat, Di-(4-trifluormethylphenyl)-iodoniumtetrafluoroborat, Diphenyliodoniumhexafluorophosphat, Di-(4-methylphenyl)-iodoniumhexafluorophosphat, Diphenyliodoniumhexafluoroarsenat, Di-(4-phenoxyphenyl)-iodoniumtetrafluoroborat, Phenyl-2-thienyliodoniumhexafluorophosphat, 3,5-Dimethylpyrazolyl-4-phenyliodoniumhexafluorophosphat, Diphenyliodoniumhexafluoroantimonat, 2,2'-Diphenyliodoniumtetrafluoroborat, Di-(2,4-dichlorphenyl)-iodoniumhexafluorophosphat, Di-(4-bromphenyl)-iodoniumhexafluorophosphat, Di-(4-methoxyphenyl)-iodoniumhexafluorophosphat, Di-(3-carboxyphenyl)-iodoniumhexafluorophosphat, Di-(3-methoxycarbonylphenyl)-iodoniumhexafluorophosphat, Di-(3-methoxysulfonylphenyl)-iodoniumhexafluorophosphat, Di-(4-acetamidophenyl)-iodoniumhexafluorophosphat, Di-(2-benzothienyl)-iodoniumhexafluorophosphat, Diaryliodoniumtristrifluormethylsulfonylmethid wie Diphenyliodoniumhexafluoroantimonat, Diaryliodoniumtetrakis-(pentafluorophenyl)-borat wie Diphenyliodoniumtetrakis-(pentafluorophenyl)-borat,, (4-n-Desiloxyphenyl)-phenyliodoniumhexafluoroantimonat, [4-(2-Hydroxy-n-tetradesiloxy)-phenyl]-phenyliodoniumhexafluoroantimonat, [4-(2-Hydroxy-n-tetradesiloxy)-phenyl]-phenyliodoniumtrifluorosulfonat, [4-(2-Hydroxy-n-tetradesiloxy)-phenyl]-phenyliodoniumhexafluorophosphat, [4-(2-Hydroxy-n-tetradesiloxy)-phenyl]-phenyliodoniumtetrakis-(pentafluorophenyl)-borat, Bis-(4-tert-butylphenyl)-iodoniumhexafluoroantimonat, Bis-(4-tert-butylphenyl)-iodoniumhexafluorophosphat, Bis-(4-tert-butylphenyl)-iodoniumtrifluorosulfonat, Bis-(4-tert-butylphenyl)-iodoniumtetrafluoroborat, Bis-(dodecylphenyl)-iodoniumhexafluoroantimonat, Bis-(dodecylphenyl)-iodoniumtetrafluoroborat, Bis-(dodecylphenyl)-iodoniumhexafluorophosphat, Bis-(dodecylphenyl)-iodoniumtrifluoromethylsulfonat, Di-(dodecylphenyl)-iodoniumhexafluoroantimonat, Di-(dodecylphenyl)-iodoniumtriflat, Diphenyliodoniumbisulfat, 4,4'-Dichlorodiphenyliodoniumbisulfat, 4,4'-Dibromodiphenyliodoniumbisulfat, 3,3'-Dinitrodiphenyliodoniumbisulfat, 4,4'-Dimethyldiphenyliodoniumbisulfat, 4,4'-Bis-succinimidodiphenyliodoniumbisulfat, 3-Nitrodiphenyliodoniumbisulfat, 4,4'-Dimethoxydiphenyliodoniumbisulfat, Bis-(dodecylphenyl)-iodoniumtetrakis-(pentafluorophenyl)-borat, (4-Octyloxyphenyl)-phenyliodoniumtetrakis-(3,5-bis-trifluoromethylphenyl)-borat und (Tolylcumyl)-iodoniumtetrakis-(pentafluorophenyl)-borat oder

Ferrocenium-Salze (siehe zum Beispiel EP 542 716 B1) wie η₅-(2,4-cyclopentadien-1-yl)-[(1,2,3,4,5,6,9)-(1-methylethyl)-benzol]-eisen.

Beispiele für kommerzialisierte Photoinitiatoren sind Cyracure UVI-6990, Cyracure UVI-6992, Cyracure UVI-6974 und Cyracure UVI-6976 der Firma Union Carbide, Optomer SP-55, Optomer SP-150, Optomer SP-151, Optomer SP-170 und Optomer SP-172 der Firma Adeka, San-Aid SI-45L, San-Aid SI-60L, San-Aid SI-80L, San-Aid SI-100L, San-Aid SI-110L, San-Aid SI-150L und San-Aid SI-180L der Firma Sanshin Chemical, SarCat CD-1010, SarCat CD-1011 und SarCat CD-1012 der Firma Sartomer, Degacure K185 der Firma Degussa, Rhodorsil Photoinitiator 2074 der Firma Rhodia, CI-2481, CI-2624, Cl-2639, CI-2064, CI-2734, CI-2855, CI-2823 und CI-2758 der Firma Nippon Soda, Omnicat 320, Omnicat 430, Omnicat 432, Omnicat 440, Omnicat 445, Omnicat 550, Omnicat 550 BL und Omnicat 650 der Firma IGM Resins, Daicat II der Firma Daicel, UVAC 1591 der Firma Daicel-Cytec, FFC 509 der Firma 3M, BBI-102, BBI-103, BBI-105, BBI-106, BBI-109, BBI-110, BBI-201, BBI, 301, BI-105, DPI-105, DPI-106, DPI-109, DPI-201, DTS-102, DTS-103, DTS-105, NDS-103, NDS-105, NDS-155, NDS-159, NDS-165, TPS-102, TPS-103, TPS-105, TPS-106, TPS-109, TPS-1000, MDS-103, MDS-105, MDS-109, MDS-205, MPI-103,, MPI-105, MPI-106, MPI-109, DS-100, DS-101, MBZ-101, MBZ-201, MBZ-301, NAI-100, NAI-101, NAI-105, NAI-106, NAI-109, NAI-1002, NAI-1003, NAI-1004, NB-101, NB-201, NDI-101, NDI-105, NDI-106, NDI-109, PAI-01, PAI-101, PAI-106, PAI-1001, PI-105, PI-106, PI-109, PYR-100, SI-101, SI-105, SI-106 und SI-109 der Firma Midori Kagaku, Kayacure PCI-204, Kayacure PCI-205, Kayacure PCI-615, Kayacure PCI-625, Kayarad 220 und Kayarad 620, PCI-061T, PCI-062T, PCI-020T, PCI-022T der Firma Nippon Kayaku, TS-01 und TS-91 der Firma Sanwa Chemical, Deuteron UV 1240 der Firma Deuteron, Tego Photocompound 1465N der Firma Evonik, UV 9380 C-D1 der Firma GE Bayer Silicones, FX 512 der Firma Cytec, Silicolease UV Cata 211 der Firma Bluestar Silicones und Irgacure 250, Irgacure 261, Irgacure 270, Irgacure PAG 103, Irgacure PAG 121, Irgacure PAG 203, Irgacure PAG 290, Irgacure CGI 725, Irgacure CGI 1380, Irgacure CGI 1907 und Irgacure GSID 26-1 der Firma BASF.

Dem Fachmann sind weitere Systeme bekannt, die ebenfalls erfindungsgemäß einsetzbar sind. Photoinitiatoren werden unkombiniert oder als Kombination von zwei oder mehreren Photoinitiatoren eingesetzt.

Vorteilhaft sind Photoinitiatoren, die Absorption bei kleiner 350 nm und vorteilhaft bei größer 250 nm aufweisen. Initiatoren, die oberhalb 350 nm absorbieren, beispielsweise im Bereich violetten Lichts, sind ebenfalls einsetzbar. Sulfonium-basierende Photoinitiatoren werden besonders bevorzugt eingesetzt, da sie eine vorteilhafte UV-Absorptionscharakteristik aufweisen.

Thermische Initiatoren für die kationische Polymerisation von Epoxiden

Thermische Initiatoren, sogenannte thermischen Säurebildner ("thermal acid generator" TAG) sind beispielsweise Benzylthiolaniumsalze mit beispielsweise PF₆⁻ , AsF₆⁻, oder SBF₆⁻ Anionen beschrieben in US 5,242,715 A, BF₃-Amin-Komplexe, beschrieben in "Study of Polymerization Mechanism and Kinetics of DGEBA with BF3-amine Complexes Using FT-IR and Dynamic DSC" (Ghaemy et al., Iranian Polymer Journal, Vol. 6, No. 1, 1997), Lanthanid Triflate beschrieben in "Study of Lanthanide Triflates as New Curing Initiators for Cycloaliphatic Epoxy Resins" (C. Mas et al., Macromolecular Chemistry and Physics, 2001, 202, No. 12) oder geblockte Supersäuren wie beispielsweise Ammonium triflate; Ammonium perfluorobutanesulfonate (PFBuS); Ammonium Ad-TFBS [4-adaman-tanecarboxyl-1,1,2,2-tetrafluorobutane sulfonate]; Ammonium AdOH-TFBS [3-hydroxy-4-adamantanecarboxyl-1,1,2,2-tetrafluorobutane sulfonate]; Ammonium Ad-DFMS [Adamantanyl-methoxycarbonyl)-difluoromethanesulfonate]; Ammonium AdOH-DFMS [3-Hydroxyadamantanyl-methoxycarbonyl)-difluoromethanesulfonate]; Ammonium DHC-TFBSS [4-dehydrocholate-1,1,2,2-tetrafluorobutanesulfonate]; and Ammonium ODOT-DFMS [Hexahydro-4,7-Epoxyisobenzofuran-1(3H)-one, 6-(2,2'-difluoro-2-sulfonatoacetic acid ester)].

Kommerziell sind solche Systeme z.B. von King Industries unter den Bezeichnungen TAG-2678, TAG-2713 oder TAG-2172 zu erhalten. Diese geblockten Säuren setzen bei erhöhten Temperaturen beispielsweise Trifluoromethansulfonsäure, p-Toluolsulfonsäure oder Dodecylbenzyl Sulfonsäure frei, die eine kationische Härtung von Epoxiden initiieren.

### Beispiele

### Messmethoden

Viskositätsmessung:
Ein Maß für die Fließfähigkeit des fluiden Beschichtungsmaterials ist die dynamische Viskosität. Die dynamische Viskosität kann nach DIN 53019 bestimmt werden. Als Fluid wird eine Viskosität von weniger als 10⁸ Pa·s bezeichnet. Die Viskosität wird in einem Zylinderrotationsviskosimeter mit einer Standardgeometrie nach DIN 53019-1 bei einer Messtemperatur von 23°C und einer Schergeschwindigkeit 1 s⁻¹ gemessen.

Molekulargewichtsverteilung:
Die Molekulargewichtsbestimmungen der zahlenmittleren Molekulargewichte Mₙ und der gewichtsmittleren Molekulargewichte M_{w} erfolgten mittels Gelpermeationschromatographie (GPC). Als Eluent wurde THF (Tetrahydrofuran) mit 0,1 Vol.-% Trifluoressigsäure eingesetzt. Die Messung erfolgte bei 25 °C. Als Vorsäule wurde PSS-SDV, 10 µ, ID 8,0 mm x 50 mm verwendet. Zur Auftrennung wurden die Säulen PSS-SDV, 10 µ ID 8,0 mm x 300 mm eingesetzt. Die Probenkonzentration betrug 1,5 g/l, die Durchflussmenge 0,5 ml pro Minute. Es wurde gegen Poly(methyl-methacrylat)-Standards gemessen.

Die Angaben der zahlenmittleren Molmasse Mₙ, der gewichtsmittleren Molmasse M_{w} und der Polydispersität in dieser Schrift beziehen sich auf die Bestimmung per Gelpermeationschromatographie (GPC) bzw. die Auswertung derartiger Messungen.

Verwendete Materialien:

| | |
|---|---|
| Uvacure 1500 | cycloaliphatisches Bis(???)-Epoxid der Firma Cytec ((3,4-epoxycyclohexane) methyl 3,4-epoxycyclohexylcarboxylate) |
| Epon Resin 828 | Difunktionelles Bisphenol-A / epichlorhydrin-Flüssigepoxid mit einem Gewicht pro Epoxid von 185 - 192 g/eq der Firma Momentive. |
| p-Toluolsulfonylisocyanat (TSI) | Elektronenarmes Mono-Isocyanat |
| TAG-2678 | ammonium geblockte Trifluormethansulfonsäure der Firma King Industries. |
| Triarylsulfoniumhexafluoroantimonat | kationischer Fotoinitiator der Firma Sigma-Aldrich |
| | Der Photoinitiator weist ein Absorptionsmaximum im Bereich 320 nm bis 360 nm auf und lag als 50 Gew.-%-ige Lösung in Propylencarbonat vor |

Beispiel 1: Initiation mit elektronenarmen Mono-Isocyanaten:
In einem 21-Polymerisationsreaktor wurden 1kg Uvacure 1500 unter Stickstoff Atmosphäre auf 85°C erwärmt. Die Viskosität des Uvacure 1500 beträgt 0,25 Pa s. Im Stickstoffgegenstrom wurde der Initiator zugegeben und die Lösung langsam gerührt.
Zur Ermittlung der Molekulargewichtsverteilungen und Viskositäten wurden während der Reaktion nach unterschiedlichen Reaktionszeiten Proben gezogen und mittels GPC und Viskosimetrie analysiert.

**Tabelle 1: GPC-Ergebnisse von erfindungsgemäßen Epoxid-Sirupen initiiert mit TSI**

| **TSI Menge** [%] | **Mw** [g mol⁻¹] | **Mn** [g mol⁻¹] | **D** | **Reaktionszeit** [h] | **Temperatur** [°C] |
|---|---|---|---|---|---|
| 6 | 13500 | 780 | 17,4 | 3,25 | 100 |
| 6 | 11100 | 740 | 15,1 | 4,25 | 100 |
| 6 | 22000 | 790 | 27,9 | 5,25 | 100 |
| 7 | 22500 | 830 | 27,3 | 1,0 | 100 |
| 7 | 59700 | 830 | 71,7 | 2,25 | 100 |
| 7 | 78400 | 850 | 92 | 3,75 | 100 |
| 7,4 | 5100 | 630 | 8 | 0,5 | 100 |
| 7,4 | 6000 | 600 | 9,9 | 1 | 100 |
| 7,4 | 16100 | 650 | 24,8 | 3,3 | 100 |

Es zeigt sich, dass die Polydispersität mit zunehmender Reaktionszeit ebenfalls zunimmt. Für die im Beispiel verwendeten Substanzen liegt bei einer TSI-Menge von 7 Gew.-% ein Reaktionsgeschwindigkeitsmaximum vor. Die Verwendung von einer größeren Initiatormenge führt hier nicht zu höheren Reaktionsgeschwindigkeiten.

**Tabelle 2: Viskositäten von erfindungsgemäßen Epoxid-Sirupen initiiert mit TSI**

| **TSI Menge** [%] | **Reaktionszeit [min]** | **Viskosität [Pa s]** |
|---|---|---|
| 6 | 30 | 10,9 |
| 6 | 60 | 40 |
| 6 | 90 | 67,2 |
| 6 | 130 | 132 |
| 6 | 180 | 203 |
| 6 | 230 | 334 |
| 7 | 30 | 39,6 |
| 7 | 60 | 115 |
| 7 | 90 | 230 |
| 7 | 120 | 420 |
| 7 | 190 | 1536 |
| 7 | 210 | 1956 |

Auch aus der Tabelle 2 lässt sich gut erkennen, dass die Reaktion mit höherer Initiatormenge deutlich schneller verläuft und ein Viskositätsanstieg sehr viel schneller erreicht wird.

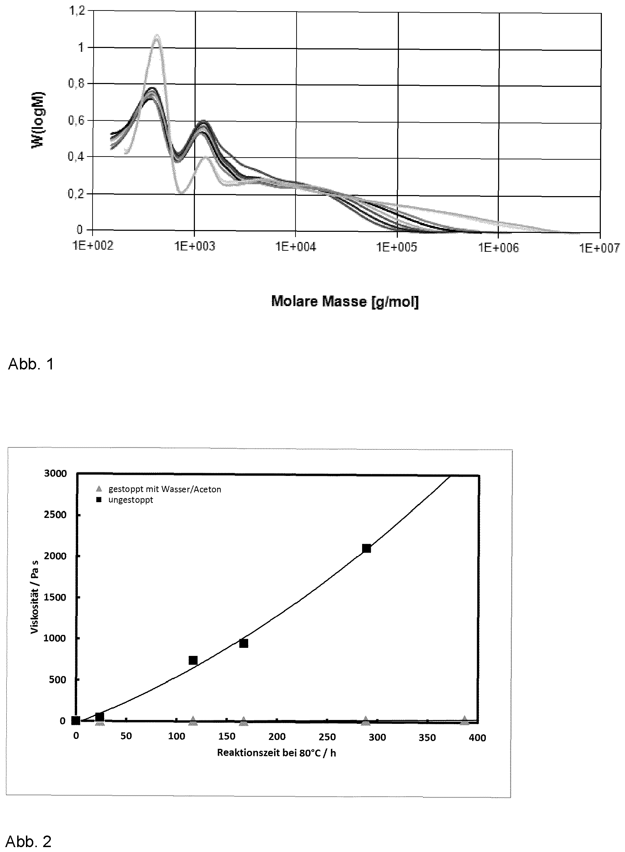

Abbildung 1 zeigt die Molekulargewichtsverteilung von über unterschiedlich lange Zeiträume polymerisierten Uvacure-Sirupen. Markant ist die enorm breite Verteilung, die viele Moleküle kleiner 1.000 g/mol enthält, aber auch bis zum Teil über 10⁶ g/mol große Ketten, die die hohe Viskosität bewirken.

### Stoppen der Reaktion

Nach Erreichen der gewünschten Viskosität wird die Reaktion gestoppt, indem eine der Initiatormenge entsprechende Menge eines Wasser-Aceton-Gemisches (Verhältnis 1:1) als Initiationsfänger zugegeben wurde. Die Abbildung 2 zeigt, dass selbst bei 80°C quasi keine weitere Polymerisation mehr erfolgt, wohingegen ohne Zugabe eines Initiationsfängers die Polymerisation stark fortschreitet.

### Beispiel 2: Inititation mit hochverdünnten Photoinitiatoren

In einem 2l-Glasreaktor wurden zu 1kg Epon Resin 828 unter Lichtausschluss und unter Stickstoffatmosphäre bei 23°C ein Photoinitiator (Triarylsulfoniumhexafluoroantimonat) unter Rühren (50 U/Min) zugegeben. Die Initiation der Reaktion erfolgte durch 2 minütige Bestrahlung mit 4 Hg-Mitteldrucklampen, die radial um den Polymerisationsreaktor positioniert waren.

Zur Ermittlung der Viskositäten wurden während der Reaktion nach unterschiedlichen Reaktionszeiten Proben gezogen und mittels GPC und Viskosimetrie analysiert.

**Tabelle 3: Viskositäten von erfindungsgemäßen Epoxid-Sirupen initiiert mit Triarylsulfoniumhexafluoroantimonat**

| Photoinitiatormenge [%] | Viskosität nach 120h [mPa s] |
|---|---|
| 0,004 | 500 |
| 0,01 | 860 |
| 0,02 | 1300 |

Es ist erkennbar, dass deutlich geringere Initiatormengen erforderlich sind und die Viskositäten bei gleicher Reaktionszeit mit zunehmender Initiatormenge ebenfalls zunehmen.

### Beispiel 3: Initiation mit hochverdünnten thermischen Initiatoren

Zu einer 30%igen Lösung aus Uvacure 1500 in Toluol wurden 0,02% TAG-2678 zugegeben und unter Rückfluss erhitzt. Nach der gewünschten Reaktionszeit wurde die Kühlung deaktiviert und das Lösungsmittel entfernt. Wie in den anderen Beispielen wurde ein vollkommen transparenter farbloser Epoxid-Sirup erhalten. Bereits nach 1h Reaktionszeit wurden im Vergleich zum Edukt mehr als doppelt so große Viskositäten gemessen.

Beispiel 3 zeigt, dass auch mit thermischen Initiatoren, in Lösung und ohne Schutzgas viskose Epoxidsirupe erzeugt werden können.

## Patentansprüche

1. Verfahren zur Herstellung eines viskosen Epoxidsirups aus mindestens einem flüssigen multifunktionellen Epoxid, umfassend die Schritte:
- Zugeben eines Initiators, ausgewählt aus der Gruppe bestehend aus elektronenarmem Monoisocyanat, Photoinitiator und thermischem Initiator, zu mindestens einem flüssigen multifunktionellen Epoxid;
- Vermischen der Komponenten;
- Polymerisieren des multifunktionellen Epoxids derart, dass die Viskosität des resultierenden Epoxidsirups mindestens doppelt so hoch, vorzugsweise mindestens viermal so hoch und insbesondere mindestens zehnmal so hoch ist wie die des eingesetzten Epoxides im nicht-umgesetzten Zustand.

2. Verfahren nach Anspruch 1, **dadurch gekennzeichnet, dass** in dem resultierenden Epoxidsirup mindestens 65%, bevorzugt mindestens 75%, insbesondere mindestens 80% der ursprünglichen Epoxidgruppen noch vorhanden sind.

3. Verfahren nach Anspruch 1 oder 2, **dadurch gekennzeichnet, dass** der resultierende Epoxidsirup hochmolekulare unvernetzte Polyepoxide enthält.

4. Verfahren nach einem der Ansprüche 1 bis 3, **dadurch gekennzeichnet, dass** das mindestens eine multifunktionelle Epoxid ein Bis-Epoxid ist.

5. Verfahren nach einem der Ansprüche 1 bis 4, **dadurch gekennzeichnet, dass** das mindestens eine multifunktionelle Epoxid ein bis-Epoxycyclohexyl-Derivat oder ein Bis-Epoxid auf Basis von Bisphenol-A, Bisphenol-S oder Bisphenol-F ist.

6. Verfahren nach einem der Ansprüche 1-5, **dadurch gekennzeichnet, dass** das mindestens eine multifunktionelle Epoxid 3,4-Epoxycyclohexylmethyl-3,4-Epoxycyclohexan Carboxylat ist.

7. Verfahren nach einem der Ansprüche 1 bis 6, **dadurch gekennzeichnet, dass** der Initiator ausgewählt ist aus der Gruppe bestehend aus Photoinitiator und thermischem Initiator und in einer Menge von höchstens 0,1 Gew.-%, vorzugsweise höchstens 0,08 Gew.-%, besonders bevorzugt höchstens 0,05 Gew.-% eingesetzt wird.

8. Verfahren nach einem der Ansprüche 1 bis 6, **dadurch gekennzeichnet, dass** der Initiator ein elektronenarmes Monoisocyanat ist und in einer Menge von höchstens 10 Gew.-%, vorzugsweise höchstens 8 Gew.-% und insbesondere höchstens 7 Gew.-% eingesetzt wird.

9. Verfahren nach Anspruch 8, **dadurch gekennzeichnet, dass** der Initiator ausgewählt ist aus der Gruppe bestehend aus p-Tolylisocyanat, o-Tolylisocyanat und Sulfonylisocyanaten, insbesondere p-Toluolsulfonylmethylisocyanat, o-Toluolsulfonylmethylisocyanat, 4-Chlorbenzylsulfonylisocyanat, o-Toluolsulfonylisocyanat, p-Toluolsulfonylisocyanat und Benzylsulfonylisocyanat, wobei p-Toluolsulfonylisocyanat besonders bevorzugt ist.

10. Verfahren nach Anspruch 8 oder 9, **dadurch gekennzeichnet, dass** es bei einer Temperatur zwischen 20 und 120°C, vorzugsweise zwischen 40 und 100°C, insbesondere bei einer Temperatur zwischen 80 und 90°C durchgeführt wird.

11. Verfahren nach einem der Ansprüche 1 bis 10, **dadurch gekennzeichnet, dass** die Polymerisation bei Erreichen einer gewünschten Viskosität durch Zugabe eines Initiatorfängers gestoppt wird.

12. Verfahren nach Anspruch 11, **dadurch gekennzeichnet, dass** als Initiatorfänger ein Gemisch aus Wasser und Aceton, Lösungen von (Erd-)Alkalihydroxiden oder Lösungen von (Erd-)Alkalialkoxiden verwendet wird.

13. Verfahren nach einem der Ansprüche 1 bis 12, **dadurch gekennzeichnet, dass** das Polymerisieren des multifunktionellen Epoxids derart erfolgt, dass der resultierende Epoxidsirup eine Polydispersität D von mindestens 3, vorzugsweise mindestens 5, insbesondere von mindestens 8 aufweist.

14. Viskoser Epoxidsirup erhältlich nach einem der Ansprüche 1 bis 13.

15. Viskoser Epoxidsirup, enthaltend multifunktionelle Epoxidmonomere und aus diesen erzeugte hochmolekulare unvernetzte multifunktionelle Polyepoxide, **dadurch gekennzeichnet dass** die Viskosität des Epoxidsirups mindestens doppelt so hoch, vorzugsweise mindestens viermal so hoch und insbesondere mindestens zehnmal so hoch ist wie die des eingesetzten Epoxides im nicht-umgesetzten Zustand.

16. Viskoser Epoxidsirup nach Anspruch 15, **dadurch gekennzeichnet dass** die Molgewichtsverteilung der im Epoxidsirup enthaltenen Polyepoxide mindestens den Bereich von 2.000 g/mol bis 300.000 g/mol umfasst.

17. Viskoser Epoxidsirup nach Anspruch 14, **dadurch gekennzeichnet dass** der Viskositätsanstieg bei Lagerung bei 25°C pro Tag kleiner als 5 Pa s ist.

18. Viskoser Epoxidsirup nach einem der Ansprüche 14 bis 17, **dadurch gekennzeichnet, dass** das Epoxidmonomer 3,4-Epoxycyclohexylmethyl-3,4-Epoxy-cyclohexancarboxylat ist und dass die Viskosität mindestens 1 Pa s (1.000 mPs) bevorzugt 10 Pa s (10.000 mPs), insbesondere 25 Pa s (25.000 mPs) beträgt.

19. Wasserdampfsperrende Klebemasse, enthaltend
eine Klebstoffbasis aus
- mindestens einem Epoxidsirup nach einem der Ansprüche 14 bis 18
- mindestens einem Elastomer
- optional ein Lösungsmittel, wobei
die Klebstoffbasis eine Wasserdampfpermeationsrate nach der Aktivierung der Reaktivharzkomponente von weniger als 100 g/m²d, bevorzugt von weniger als 60 g/m²d, insbesondere weniger als 30 g/m²d aufweist.

20. Klebeband enthaltend einen viskosen Epoxidsirup nach einem der Ansprüche 14 bis 18 oder eine wasserdampfsperrende Klebemasse nach Anspruch 19.

21. Verwendung der Klebemasse nach einem der Ansprüche 14 bis 18, der Klebemasse nach Anspruch 19 oder des Klebebandes nach Anspruch 20 zur Verkapselung von Aufbauten in der organischen Elektronik.
